# EUROPEAN PATENT SPECIFICATION

(11) **EP 2 182 558 B1**
(45) Date of publication and mention of the grant of the patent: **21.05.2014**
(21) Application number: 08739443.3
(22) Date of filing: 31.03.2008
(51) Int. Cl.: H01L 35/32, H01L 35/34, H02N 11/00, H01L 35/16, C30B 11/00, C30B 29/52

(54) **THERMOELECTRIC ELEMENT, THERMOELECTRIC MODULE, AND METHOD FOR MANUFACTURING THERMOELECTRIC ELEMENT**
THERMOELEKTRISCHES ELEMENT, THERMOELEKTRISCHES MODUL UND VERFAHREN ZUR HERSTELLUNG EINES THERMOELEKTRISCHEN ELEMENTS
ELÉMENT THERMOÉLECTRIQUE, MODULE THERMOÉLECTRIQUE ET PROCÉDÉ DE FABRICATION DE L'ÉLÉMENT THERMOÉLECTRIQUE

(30) Priority: 25.07.2007 JP 2007193214
(43) Date of publication of application: 05.05.2010
(73) Proprietor: Kyocera Corporation, Kyoto-shi, Kyoto-fu 612-8501 (JP)
(72) Inventor: FUJIE, Kazuyuki, Kirishima-shi Kagoshima 899-4396 (JP)
(74) Representative: HOFFMANN EITLE
(86) International application number: PCT/JP2008/056329
(87) International publication number: WO 2009/013918

(56) References cited:
- JP-A- 09 181 360
- JP-A- 10 004 217
- JP-A- 10 032 355
- JP-A- 11 317 547
- JP-A- 2003 347 608
- JP-A- 2006 253 341
- JP-A- 2006 294 935
- JP-U- 03 038 650
- US-A1- 2006 102 224
- RONGGUI YANG ET AL: "Thermal Conductivity Modeling of Core-Shell and Tubular Nanowires", NANO LETTERS, vol. 5, no. 6, 1 June 2005 (2005-06-01), pages 1111-1115, XP055045146, ISSN: 1530-6984, DOI: 10.1021/nl0506498

## Description

### Technical Field

The present invention relates to a thermoelectric element which is used for cooling an exothermic body such as a semiconductor and so forth.

### Background

Conventionally, a thermoelectric element has been used as a cooling element or a heating element. It utilizes the Peltier effect, wherein one end of the thermoelectric element generates heat and the other end absorbs heat when an electric current is passed through the element. A thermoelectric module is constructed by, for example, connecting a plurality of thermoelectric elements in series. When an electric current is passed through these thermoelectric elements which construct the thermoelectric module, one end of the module acts as a heating part and the other end thereof act as a cooling part. Thus, it is possible to use the thermoelectric module as a cooling element or a heating element.

Alternatively, by heating one end face and cooling the other end face, a temperature difference is generated between the both ends of the thermoelectric element. Thus, the thermoelectric module may be used as an electric power generation element.

The thermoelectric module using such thermoelectric element has been expected to be utilized in wide fields, for example, in a cooling device, a refrigerator, a constant-temperature bath, a seat cooling apparatus for a vehicle, an electronic cooling element for a light-detecting element, a laser diode, a temperature controller in a semiconductor-producing apparatus or the like. '

It is desired for the thermoelectric module using the thermoelectric element, to have higher thermoelectric properties and to enlarge the temperature difference between the both ends of the thermoelectric element. Thus, it is proposed to improve the thermoelectric properties by using an amorphous material for the material of the element (Patent Document 1).

### Patent Document 1: JP 2003-31860 A

### Disclosure of Invention

### Problems to be Solved by the Invention

As disclosed by Patent Document 1, it is possible to improve the thermoelectric properties to some extent when an amorphous material is used for the thermoelectric element. However, there is a limit on the improvement of the thermoelectric properties by using an amorphous material for the thermoelectric element. On the other hand, it is required for the thermoelectric module to cause a further enlarged temperature difference.

The publication by RONGGUI YANG ET AL entitled "Thermal Conductivity Modeling of Core-Shell and Tubular Nanowires", NANO LETTERS, vol. 5, no. 6, 1 June 2005 (2005-06-01), pages 1111-1115, XP055045146, ISSN: 1530-6984, DOI: 10.1021/nI0506498 discloses a thermoelectric element having a pillar shape (nanowire) and having one end face and the other end face comprising a first region (silicon core) containing a central axis; and a second region (germanium shell) located at outside of the first region. The first region has a thermal conductivity different from that of the second region.

The present invention has been devised in view of the above circumstances and it is an object of the invention to provide a thermoelectric element having high thermoelectric properties, in which element the temperature difference between the both ends thereof can be enlarged, and a thermoelectric module.

### Means for Solving the Problems

The present invention provides a first thermoelectric element characterized by having a pillar shape having one end face and the other end face, comprising a first region containing a central axis and a second region arranged at a lateral side of the first region and having a protrusion which protrudes toward the central axis, wherein the first region has a thermal conductivity different from that of the second region.

### Advantage

In the thermoelectric element of the present invention, the second region, which is located at a lateral side of the first region and has a thermal conductivity different from that of the first region, has a protrusion which protrudes toward the central axis. Accordingly, it is possible to cause turbulence in the heat flow which flows between a heating end and another cooling end. Thus, it is possible to suppress a heat transfer within the thermoelectric element.

Therefore, the thermoelectric element of the present invention can improve the thermoelectric properties.

### BRIEF DESCRIPTION OF THE DRAWINGS

Fig. 1 is a sectional view showing a thermoelectric element in a first embodiment according to the present invention.
Fig. 2A is a sectional view showing a thermoelectric element in a second embodiment according to the present invention.
Fig. 2B is an enlarged sectional view of a part of Fig. 2A.
Fig. 3 is a sectional view showing a thermoelectric element in a third embodiment according to the present invention.
Fig. 4 is a sectional view showing a first modified example in the third embodiment according to the present invention.
Fig. 5 is a sectional view of the thermoelectric element shown in Fig. 4.
Fig. 6A is a sectional view showing a thermoelectric element in a fourth embodiment according to the present invention.
Fig. 6B is a sectional view taken along lines Y-Y in FIG. 6A;
Fig. 7A is a sectional view showing a thermoelectric element in a fifth embodiment according to the present invention.
Fig. 7B is a sectional view taken along lines Z-Z in FIG. 7A;
Fig. 8 is a sectional view showing a thermoelectric element in a sixth embodiment according to the present invention.
Fig. 9 is a sectional view showing a method for manufacturing the thermoelectric element in the first embodiment according to the present invention.
Fig. 10 is a sectional view according to the embodiment shown in Fig. 9.
Fig. 11 is a sectional view according to the embodiment shown in Fig. 9.
Fig. 12 is a sectional view according to the embodiment shown in Fig. 9.
Fig. 13 is a sectional view according to the embodiment shown in Fig. 9.
Fig. 14 is a sectional view according to the embodiment shown in Fig. 9.
Fig. 15 is a sectional view according to the embodiment shown in Fig. 9.
Fig. 16 is a sectional view according to the embodiment shown in Fig. 9.
Fig. 17A is a sectional view according to the embodiment shown in Fig. 9.
Fig. 17B is a sectional view according to the embodiment shown in Fig. 9.
Fig. 18 is a sectional view showing an embodiment according to a thermoelectric module of the present invention.

### Reference Numerals

- 1:: thermoelectric element,
- 1a:: p-type thermoelectric element,
- 1b:: N-type thermoelectric element,
- 3:: first region,
- 5:: second region,
- 7:: protrusion,
- 9:: apex,
- 11:: peripheral portion,
- 13:: intermediate region,
- 15:: mold,
- 17:: release material,
- 19:: first portion,
- 21:: second portion,
- 23:: thermoelectric module,
- 25:: electrode,
- 27:: bonding material,
- 29:: substrate,
- 31:: lead-out electrode,
- 33:: second bonding material,
- 35:: solution,
- 37:: plating layer,
- 39:: second plating layer.

### Detailed Description of the Preferred Embodiments

Hereinafter, a thermoelectric element of each embodiment according to the present invention will be explained in detail with reference to the accompanying drawings.

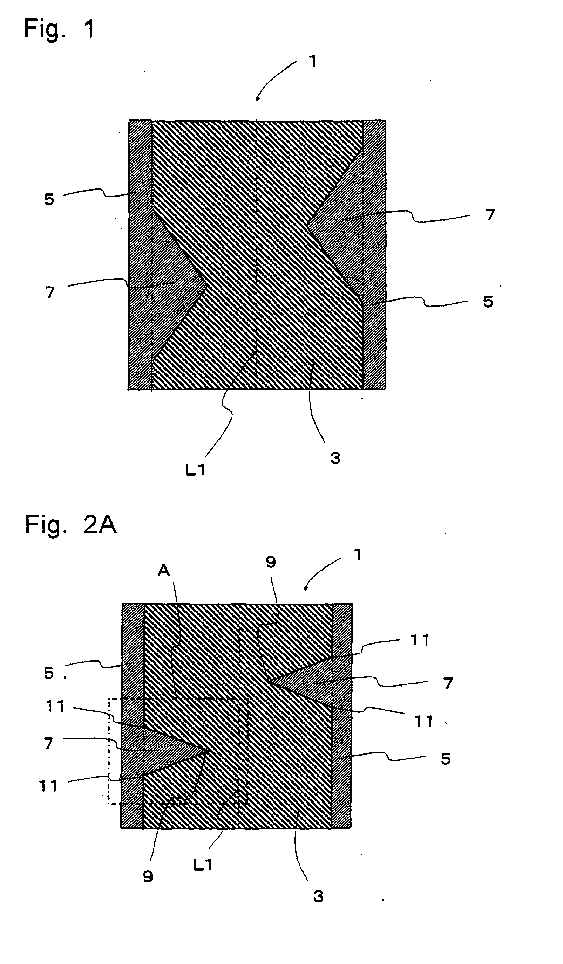

As shown in Fig. 1, the thermoelectric element 1 according to the first embodiment has a pillar shape, comprises one end face (a face on one end) and the other end face (a face on the other end) and has a central axis. In addition, the thermoelectric element 1 according to this embodiment comprises a first region 3 containing the central axis L1 of the thermoelectric element 1 and a second region 5 which is located at a lateral (outward) side of the first region 3 and has a thermal conductivity lower than that of the first region 3. In addition, the second region 5 has a protrusion 7 which protrudes from the lateral side of the first region 3 toward the central axis L1. Therefore, the thermoelectric element of this embodiment has characteristic operations and effects as described below.

The thermoelectric element generates heat on one end and absorbs heat on another end according to the Peltier effect by passing an electric current therethrough. Therefore, a temperature difference may be caused between the one end and the other end of the thermoelectric element. However, in the thermoelectric element wherein such temperature difference is caused, a heat flow which tends to reduce the temperature difference is generated in the thermoelectric element from one end toward the other end. According to such heat flow, it is inhibited from enlarging the temperature difference between the one end and the other end.

On the other hand, in the thermoelectric element 1 of this embodiment, the second region 5 having a thermal conductivity which is different from that of the first region 3 has the protrusion 7 as mentioned above. At the boundary of the first region 3 and the protrusion 7 where there is the difference of the thermal conductivities, a turbulence should be caused in the heat flow which flows from the one end toward the other end of the thermoelectric element 1. Thus, it is possible to suppress a heat transfer within the thermoelectric element.

In addition, as shown in this embodiment, it is preferable that the second region 5 has a thermal conductivity lower than that of the first region 3. Since the protrusion 7 acts as a barrier which inhibits the heat flow flowing through the first region 3, it is possible to further suppress the heat transfer within the thermoelectric element 1. Accordingly, the thermoelectric properties of the thermoelectric element 1 can be improved. As a result, it is possible to generate a large temperature difference between the one end and the other end when an electric current passes through the thermoelectric element 1.

In order to cause the heat conductivity of the first region 3 lower than that of the second region 5, for example, it is suitable to use a component having lower heat conductivity rather than the component constructing the first region 3 as the material constructing the second region 5.

The composition of the thermoelectric element 1 which has both the first region 3 and the second region 5 may be measured as mentioned below. At first, the thermoelectric element 1 is cut to obtain a sample in which the protrusion 7 is exposed. Then, the sample is subjected to a chemical analysis, for example ICP (inductively-coupled plasma) optical emission spectrometry, thereby the compositions of the first region 3 and the second region 5 can be determined. Alternatively, the cut surface of the thermoelectric element 1 may be analyzed by being subjected to EPMA (Electron Probe Micro Analysis) and so forth.

Next, the second embodiment of the present invention is explained.

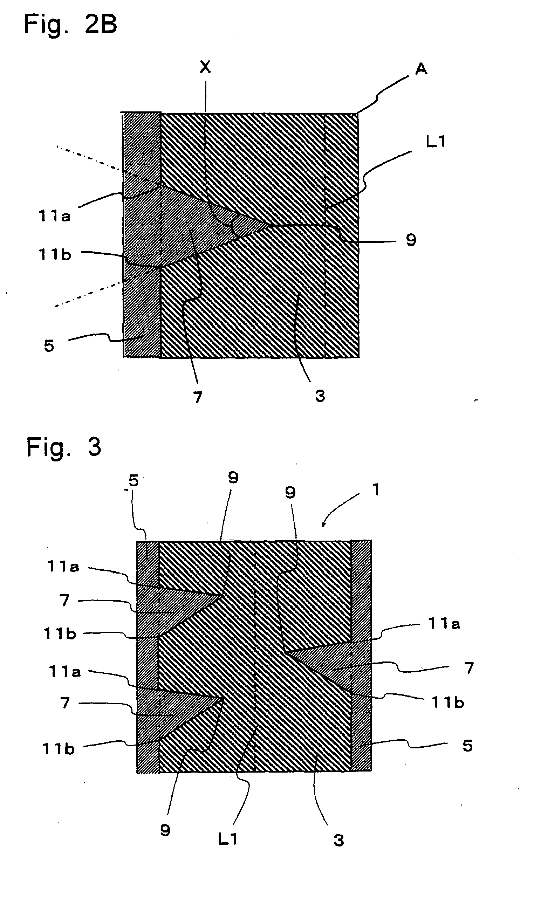

As shown in Figs. 2A and 2B, in this embodiment, the protrusion 7 has an apex 9 and two peripheral portions 11 in a section containing a central axis L1 of the thermoelectric element 1. In addition, a straight line connecting the apex 9 and one peripheral portion 11a at the one end side of the thermoelectric element 1 intersects with a straight line connecting the apex 9 and the other peripheral portion 11b at the other end side of the thermoelectric element 1 at an angle X, which is an acute angle.

In other words, the internal angle at the apex 9 in the triangle (the sectional triangle) consisting of the apex 9 and the peripheral portions 11a and 11b is an acute angle. Hereinafter, this embodiment will be explained with reference to the sectional triangle, which is intended to help the skilled person to clearly understand this embodiment of the invention. Thus, it is not necessarily intended that the sectional shape of the protrusion 7 has a triangle.

The effect of heat flow suppression of the protrusion 7 depends on the protruding extent of the apex from the lateral side of the first region 3 toward the central axis L1. Thus, in the case where the protrusion 7 has the shape as mentioned above, the heat flow can be efficiently suppressed.

In particular, in the case where the first region 3 has higher thermoelectric properties than the second region 5, the volume of the first region 3 may be increased and the volume of the second region 5 may be decreased, while maintaining the heat flow suppression effect caused by the second region 5. Thus, it comes to possible to enlarge the heat difference between the both ends of the thermoelectric element 1.

In order to make the volume of the first region 3 larger, it is preferable that the protrusion 7 has a triangular sectional shape, wherein the side connecting the peripheral portion 11a and the peripheral portion 11b has the shortest length therein.

Here, the central axis of the thermoelectric element 1 means a straight line connecting each of the center points in the one end face and the other end face of the thermoelectric element 1. For example, in the case where the thermoelectric element 1 has a circular pillar shape, the term "center point" means the center of each of the end faces having the circular shape. In the case where the thermoelectric element 1 has a square pillar shape, the term "center point" means the intersection of the diagonal lines in each of the end faces having the square shape. Thus, the section containing the central axis of the thermoelectric element 1 can be referred to as a section which contains the central axis and also a section which contains each of the center points of the one end face and the other end face as described above.

The apex 9 means the part which has the least length from the central axis L1 of the thermoelectric element 1 on the surface of the protrusion 7. In addition, each of the peripheral portions 11 means the portions which have the maximum length from the central axis L1 of the thermoelectric element 1 on the surface of the protrusion 7 at a side closer to the one end and a side closer to the other end.

Further, it is preferable that the apex of the protrusion 7 has a pointed cusp shape in the section containing the central axis of the thermoelectric element 1. The apex 7 having such a shape can provide a wedge action, so that the close bonding between the second region 5 and the first region 3 can be improved.

Next, the third embodiment of the present invention is explained.

As shown in Fig. 3, the protrusion 7 in the thermoelectric element 1 in this embodiment has a lopsided shape wherein the apex 9 is located at a side close to the one end side rather than the plane which is parallel to the end face and which passes through a midpoint between the two peripheral portions 11a and 11b.

That is, in the sectional triangle as shown in Fig. 3, a side connecting the apex 9 and the peripheral portion 11a is shorter than another side connecting the apex 9 and the peripheral portion 11b.

Since the apex 9 has the shape as mentioned above, it is possible to further improve the thermoelectric properties of the thermoelectric element 1. It is because the direction of the heat flow is opposite to the direction of the electron flow or hole flow and in the case where the apex 9 is biased toward the one end side as described in the above, the electron flow or hole flow does not inhibited and the heat flow can be effectively inhibited.

Specifically, the direction of hole flow is opposite to the direction of the heat flow in P-type thermoelectric elements, and the direction of electron flow is opposite to the direction of the heat flow in N-type thermoelectric elements. Further, in the case where the apex 9 is biased toward the one end side as described in the above, the effect to prevent heat flow from the one end side, toward which side the protrusion inclines, to another end side is increased. Contrary to it, the effect to prevent electron flow or hole flow from the other end side toward the one end side is decreased.

In the case where the protrusion 7 is formed as shown in Fig. 3, the protrusion 7 is inclined toward the one end side, so that the bonding between the second region 5 and the first region 3 can also be improved.

As shown in Fig. 3, in a section containing the central axis L1 of the thermoelectric element 1, in the case where one second region 5 has a plurality of protrusions 7, wherein at least two second regions 5 are arranged apart from each other, each of the apex 9 and the peripheral portions 11a and 11b is defined according to the above described definition in each of the protrusions 7. That is, on the surface of each protrusion 7, each of the parts which have the least length from the central axis L1 of the thermoelectric element 1 is called as the apex 9, respectively.

Moreover, the peripheral portion 11a of the protrusion 7 at the side closer to the one end side means the portion, which is located closer to the one end than the apex 9 of the protrusion 7 and located closer to the other end than the apex 9 of an adjacent protrusion 7 which is located on the side closer to the one end side, and which has the maximum length from the central axis L1 of the thermoelectric element 1, on the inner surface of the second region 5.

Similarly, the peripheral portion 11b of the protrusion 7 at the side closer to the other end side means the portion, which is located closer to the other end than the apex 9 of the protrusion 7 and located closer to the one end than the apex 9 of an adjacent protrusion 7 which is located on the side closer to the other end side, and which has the maximum length from the central axis L1 of the thermoelectric element 1, on the inner surface of the second region 5.

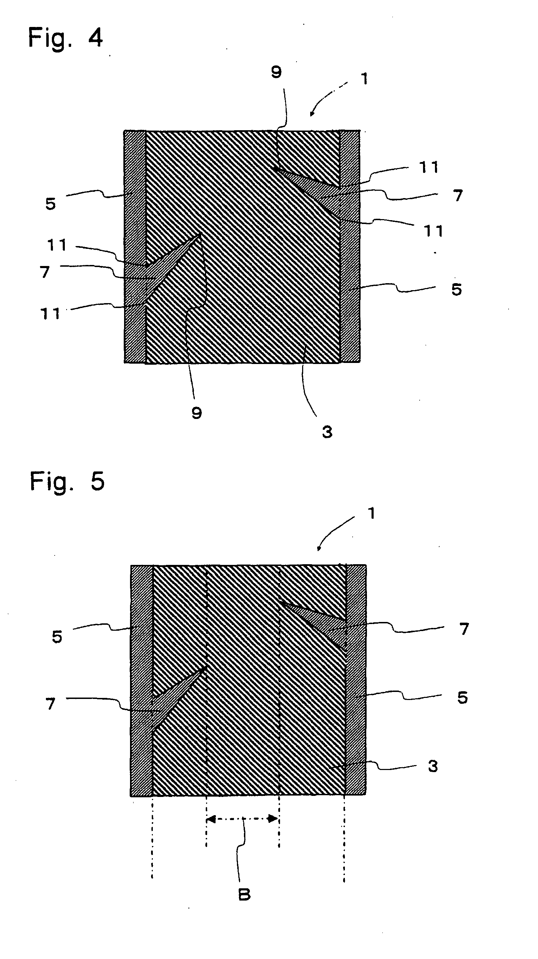

Further, in this embodiment, as shown in Fig. 4, the protrusion 7 has an inclined shape wherein the apex 9 is located at the side closer to the one end rather than the plane parallel to the end face and passing through the peripheral portion 11a. That is, the sectional triangle has an obtuse angle at the peripheral portion 11a close to one end side. Thus, it is possible to effectively inhibit the heat flow without inhibiting the electron (hole) flow. As a result, the thermoelectric properties can be further improved.

Since the protrusion 7 having the above shape is present, a part of the heat flow turns over, thereby a convection flow is generated. Thus, the heat flow is at least partially offset by each other, so that the temperature difference between the both ends of the thermoelectric element 1 may be further increased.

In addition, in the case where the protrusion 7 is formed to have the shape as shown in Fig. 4, the inclined angle of the protrusion 7b is excessive, so that the bonding between the second region 5 and the first region 3 can be further improved.

It is preferable that the second region 5 has a plurality of protrusions 7 and each of the protrusions 7 has the shape inclined toward the one end side as shown in Figs. 3 and 4. In this context, the shape inclined toward the one end side means the shape wherein the apex 9 is located at a side closer to one end side as shown in Figs. 3 and 4.

In the case where the second region 5 has a plurality of such protrusions 7, it is possible to inhibit the heat flow from the one end side toward the other end side in a stepwise fashion, so that the effect to inhibit the heat flow may be increased. As a result, the temperature difference between the both ends of the thermoelectric element 1 may be further increased.

In the case where the second region 5 has a plurality of protrusions 7, it is more preferable that the protrusion 7 is partially formed with respect to the first region 3 when the protrusion 7 is projected onto the plane which is parallel to the end face of the thermoelectric element 1. Since the first region 3 and the protrusion 7 are formed to have such a relationship, a current path may be safely secured at the central region and the electric resistance of the thermoelectric element 1 may be reduced. As a result, the temperature difference caused by the Peltier effect may be increased.

Specifically, the first region 3 preferably has a region B which is surrounded by two parallel straight lines and which has no protrusion 7 therein in a section containing the central axis of the thermoelectric element 1 as shown in Fig. 5.

Further, it is preferable that the above two straight lines are parallel to the central axis of the thermoelectric element 1. Since the electron (hole) flow is parallel to the central axis of the thermoelectric element 1, the presence of such region B helps to decrease the electric resistance of the thermoelectric element 1. As a result, the temperature difference between the both ends of the thermoelectric element 1 may be further increased.

Next, the fourth embodiment of the present invention is explained.

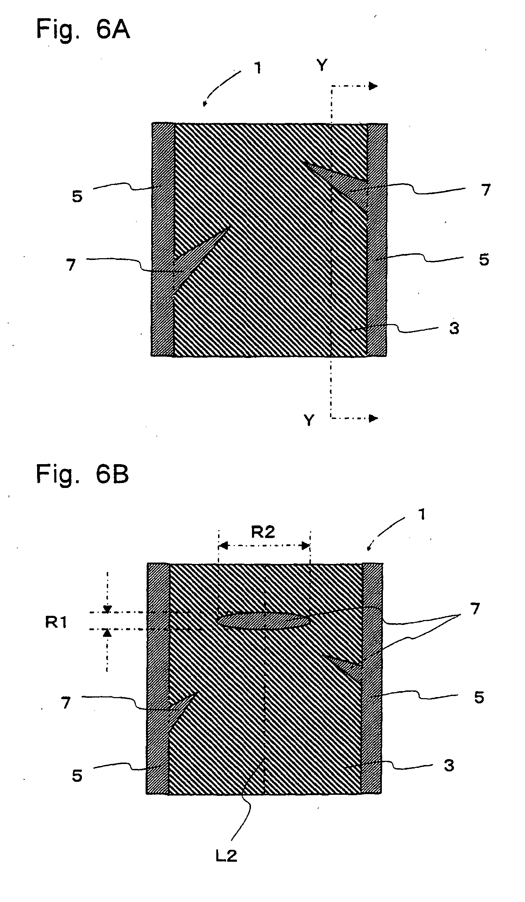

As shown in Fig. 6B, the protrusion 7 has a shape wherein a width R2 in the direction perpendicular to the central axis is larger than a width R1 in the direction parallel to the central axis in a section which is parallel to the central axis of the thermoelectric element 1.

In the case where the protrusion 7 has the above shape, the heat flow may be further effectively inhibited without enlarging the volume of the protrusion 7. It is because the protrusion 7 may retain a large area perpendicular to the heat flow without enlarging the volume of the protrusion 7.

The shape of the above protrusion 7 is measured by a section parallel to the central axis of the thermoelectric element 1 as shown in Fig. 6B. Specifically, the protrusion 7 is exposed on a central line L2 in the width direction of the section. The width R1 in the direction parallel to the central axis in the section of the exposed protrusion 7 is compared with the width R2 in the direction perpendicular to the central axis, and when the width R2 is larger than the width R1, the above effect can be attained.

Next, the fifth embodiment of the present invention is explained.

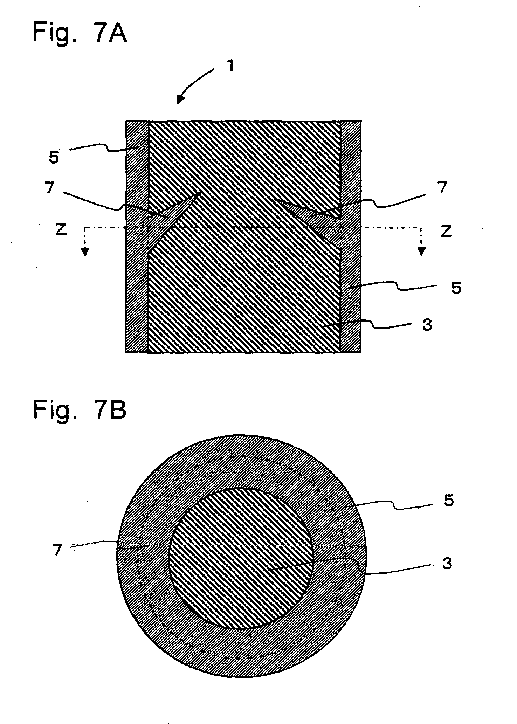

As shown in Figs. 7A and 7B, the protrusion 7 is preferably formed in an annular shape which surrounds the first region 3. When the protrusion 7 having such shape is formed, the second region 5 performs as a reinforcing member for the first region 3, so that the possibility that cracks form in the first region 3 may be reduced.

When the protrusion 7 having the above shape is formed, it is possible to reduce a deviation of the heat flow in the section containing the central axis of the thermoelectric element 1. Thus, the temperature difference between the both ends of the thermoelectric element 1 may be further increased.

In the case where the second region 5 induces compressive stress to the first region 3, the second region 5 squeezes the first region 3, so that the bonding between the second region 5 and the first region 3 may be improved. As a result, detachment of the second region 5 from the first region 3 may be effectively inhibited.

It is preferable that the first region 3 contains the main component of the second region 5. Accordingly, the difference of the heat expansion between the first region 3 and the second region 5 may be decreased, so that detachment of the second region 5 from the first region 3 due to the heat expansion or the heat contraction of the thermoelectric element 1 may be inhibited. In the case where the first region 3 and the second region 5 are formed simultaneously, the bonding between the second region 5 and the first region 3 may be further improved.

Next, the sixth embodiment of the present invention is explained.

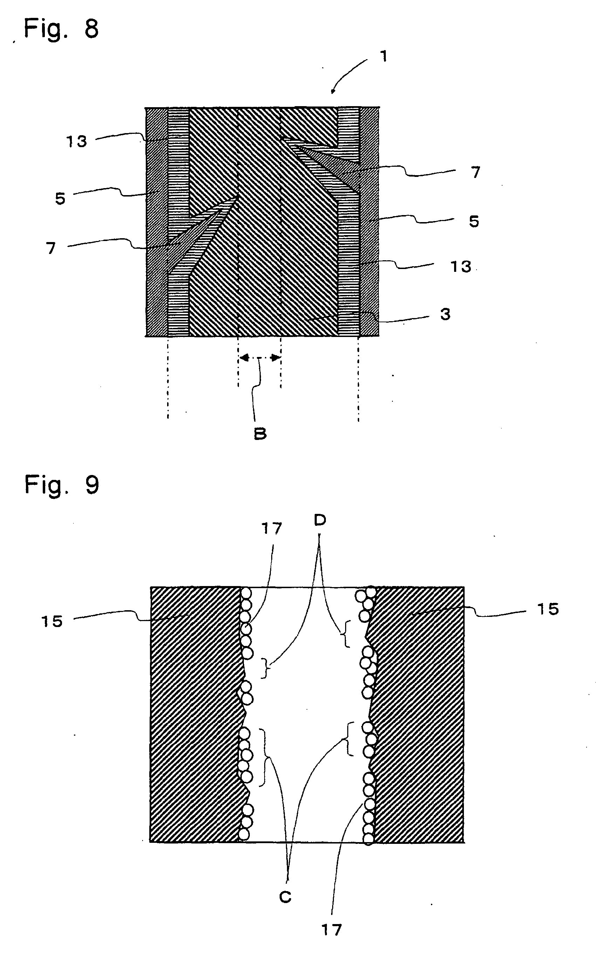

It is preferable that the first region 3 has an intermediate region 13, which contains a larger quantity of the main component of the second region 5 at the lateral portion contacting with the second region 5 rather than the central portion as shown in Fig. 8. When such intermediate region 13 is formed, the difference of the heat expansion between the first region 3 and the second region 5 may be decreased gradually. Thus, the bonding between the second region 5 and the first region 3 may be further improved.

In particular, it is preferable that, in the section which includes the central axis of the thermoelectric element 1, the portion of the first region 3 except for the intermediate region 13 contains the above region B. In the case where the first region 3 is formed as mentioned above, the region B is contained by the portion except for the intermediate region 13 in the first region 3 which has a small electric resistance, so that the electric resistance value of the thermoelectric element 1 may be further decreased. As a result, the temperature difference between the both ends of the thermoelectric element 1 may be further increased.

As shown in Figs. 1-8, the second region 5 preferably covers the lateral surface of the first region 3. Since the second region 5 is formed as mentioned above, the first region 3 is inhibited to be exposed to the ambient air. In particular, when the thermal conductivity of the second region 5 is lower than that of the first region 3, inflow and outflow of heat between the first region 3 and the ambient air is inhibited. As a result, the cooling property or power generation property may be improved.

When the first region 3 is covered by the second region 5, the protrusion 7 has a shape which protrudes from innermost surface of the second region 5, which surface is closer to the first region 3, toward the central axis.

The material of the first region 3 preferably has improved thermoelectric properties. Specifically, an alloy containing two or more elements selected from the group consisting of Bi, Sb, Te, Se, I and Br is suitable.

The material of the second region 5 may be a material which has at least different thermal conductivity from that the thermoelectric element 1. Specifically, as with the first region 3, the material of the second region 5 is preferably an alloy which contains two or more kinds of elements selected from the above group and which has a thermal conductivity lower than that of the first region 3.

In particular, it is preferable that the materials of the second region 5 and the first region 3 contain the same kinds of elements, and the composition ratio of the second region 5 differs from that of the first region 3. Since the second region 5 and the first region 3 contain the same kinds of elements, the bonding between the second region 5 and the first region 3 can be improved.

Next, the seventh embodiment of the present invention is explained.

The thermoelectric element 1 of this embodiment is a thermoelectric element having a pillar shape comprising, one end face and the other end face, a first region 3 containing a central axis, and a second region 5 located at outside of the first region 3 and having a protrusion 7 which protrudes toward the central axis.

The first region 3 includes Te and one or more elements selected from the group consisting of Bi, Sb, Se, I and Br. The second region 5 contains Te and one or more elements selected from the group consisting of Bi, Sb, Te, Se, I and Br. In addition, the second region 5 contains Te in a content which is higher than that of the first region 3.

In the case where each of the first region 3 and the second region 5 is constructed by the above components, the protrusion 7 acts as a barrier to inhibit the heat flow flowing through the first region 3, so that the heat transfer within the thermoelectric element 1 may be further inhibited. As a result, the thermoelectric properties of the thermoelectric element 1 may be increased and further large temperature difference can be generated between one end and the other end when an electric current is passed through the thermoelectric element 1.

As a method for manufacturing the above thermoelectric element 1, a method comprising solidifying and molding a thermoelectric material represented by the above group by hot pressing may be included. Specifically, by providing two kinds of thermoelectric materials having different thermal conductivities, covering a first thermoelectric material having relatively higher thermal conductivity with a second thermoelectric material having relatively lower thermal conductivity and hot-pressing them, a thermoelectric element 1 comprising a first region 3 and a second region 5, which is located at a lateral side of the first region 3 and having a thermal conductivity lower than that of the first region 3 can be produced.

Further, for example, by forming a recess on a lateral surface of the first thermoelectric material and filling the recess with a second thermoelectric material, a protrusion 7 which is located at outside of the first region 3 and protrudes toward the central axis can be formed in the second region 5.

Next, a method for manufacturing the thermoelectric element of the present invention will be explained in detail with reference to the drawings.

The method for manufacturing the thermoelectric element of this embodiment has differences from the conventional processes as follows:
(1) First, in conventional processes, a thermoelectric element was manufactured using a solution containing the first component and the second component in a stoichiometric proportion, which corresponds to the composition of the thermoelectric element as the finished product (hereinafter referred to as "standard composition"), while in the present method for manufacturing the thermoelectric element, a solution which contains either one of the first and second components excessively, specifically which contains the second components excessively is used;
(2) A part of an inner surface of the mold, into which the solution was introduced, is coated with a release material 17, thereby a part which is coated with the release material and another part which is not coated with the release material are formed on the inner surface of the mold;
(3) The mold into which the solution was introduced is cooled from one end side.

That is, as shown in Figs. 9-17, the method for manufacturing the thermoelectric element of this embodiment comprises a first step of coating a part of the inner surface of the mold 15 with the release material 17, a second step of introducing the solution 35 of the thermoelectric element 1 containing the first component and the second component which solution excessively contains the second component into the mold 15, and a third step of cooling the mold 15 into which the solution 35 was introduced from one end side.

The solution 35 of the thermoelectric element 1 containing the second component excessively means that the solution contains the second component at an excessive amount compared with the solution which contains the first component and the second component in a predetermined stoichiometric proportion which corresponds to the composition of the finished product (standard composition).

In detail, according to the method for manufacturing the thermoelectric element of this embodiment, the inner surface of the mold 15 is partially coated with a release material 17, at first. Thereby, the inner surface of the mold 15 is made to have a part C which is coated with the release material 17 and a part D where the inner surface is exposed without being coated with the release material 17.

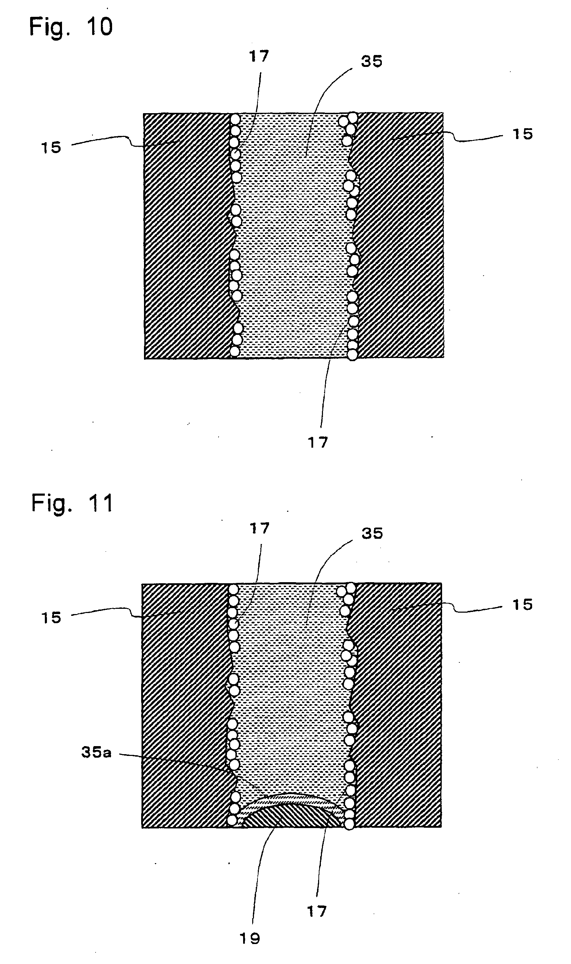

Then, as shown in Fig. 10, a solution 35 containing two kinds of materials of the thermoelectric element as the components is introduced into the mold 15. Here, in the two kinds of materials of the thermoelectric element, the component, which lowers the thermal conductivity when it is contained in excess of the standard composition ratio, is referred to as the second component and the other component is referred to as the first component. The solution 35 of the thermoelectric element 1 contains the second component excessively when it is introduced into the mold 15. Here, as described in the above, "containing the second component excessively" means that the solution contains the second component in an excess amount, so that the proportion of the second component becomes higher than that in the stoichiometric proportion of the particular compound consisting of the first component and the second component.

Then, as shown in Figs. 11-16, the mold 15 into which the above solution 35 was introduced is cooled. As shown in Fig. 11, the mold 15 is cooled from one end side (from the bottom side in Fig. 11). Since the mold 15 is cooled from one end side, the compound containing the above first component and the second component mainly precipitates from one end side, thereby a first portion 19 is formed.

Here, in the first portion 19, each of the first component and the second component precipitates in almost the stoichiometric proportion. In other words, the first portion 19 contains the first component and the second component in almost the standard composition ratio.

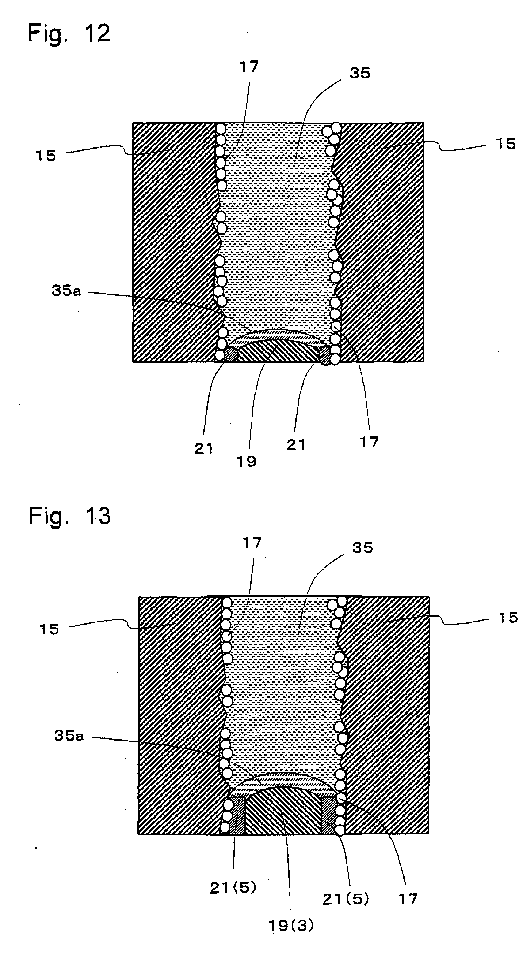

On the other hand, the solution 35 contains the second component excessively. By forming the first portion 19 in which the compound containing the first component and the second component substantially precipitates in the stoichiometric proportion, the concentration of the second component in the solution 35 increases. At the part 35a near the precipitated first portion 19, a crystal of the compound containing the first component and the second component grows, so that the concentration of the second component particularly increases. When the concentration of the second component exceed a predetermined value, a second portion 21 where the second component mainly precipitates is produced near the inner surface of the mold 15 as shown in Fig. 12. In this way, around the first portion 19, the second portion 21 where the second component mainly precipitates is produced.

It is because the mold 15 is cooled from one end side, thereby the center part apart from the inner surface is further cooled rather than the part near the inner surface of the mold 15 in the solution 35, and the first portion 19 is produced to have an expanded form which protrudes toward the other end side as shown in Fig. 12.

In this way, the mold 15 is cooled from one end side so that the center part is cooled earlier than the lateral part in the mold, thereby the first portion 19 almost having the standard composition ratio is formed at the center part. At the lateral part in the mold 15 which is cooled later and around the center part, the second portion 21 containing the second component excessively is formed.

That is, the first portion 19 and the second portion 21 are formed, thereby the first portion 19 becomes to the first region 3 and the second portion 21 becomes to the second region 5, as shown in Fig. 13. As a result, the thermoelectric element 1 in which the second region 5 having lower thermoelectric properties than the first region 3 surrounds the lateral face of the first region 3 can be produced.

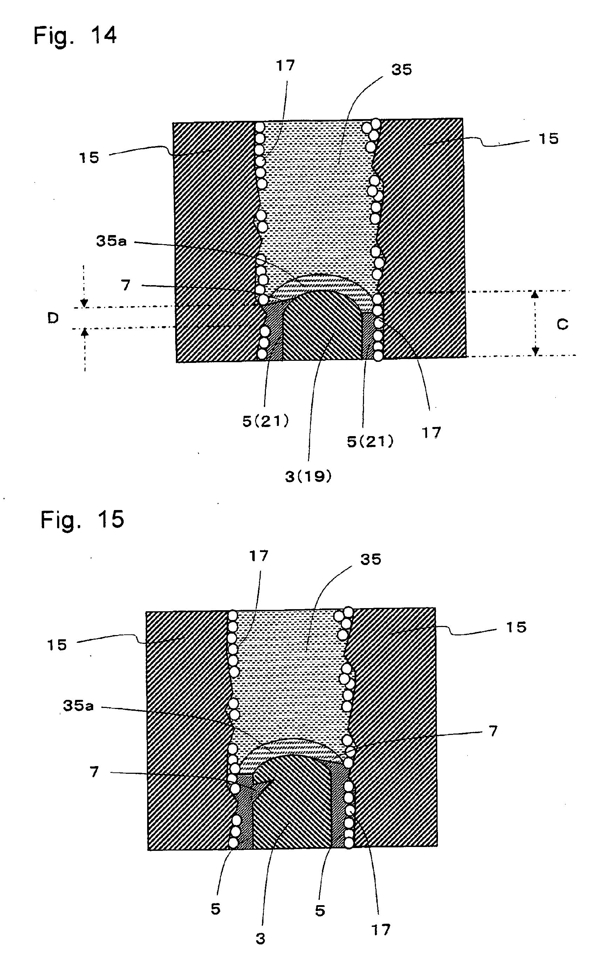

In addition, in the part D, where the inner surface is exposed without being coated with the release material 17 in the inner surface of the mold 15, the mold has a better wettability with the thermoelectric material rather than the part C, which is coated with the release material 17, so that the precipitation of the second component is facilitated as shown in Fig. 14. In addition, as mentioned in the above, at the part near the precipitated first portion 19, particularly, the concentration of the second component increases, so that the precipitation of the second component is facilitated at the part near the surface of the precipitated first portion 19. Thus, the protrusion 7 which is located at outside of the first region 3 and protrudes toward the central axis is produced.

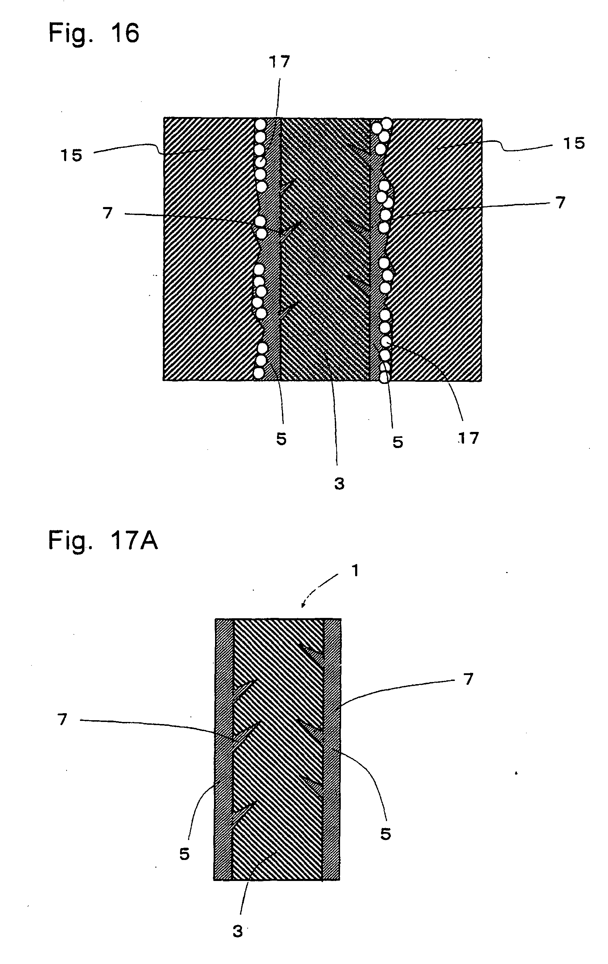

Then, in the similar way to the above, the first component and the second component precipitate, so that a plurality of protrusions 7 are produced as shown in Figs. 15 and 16. Thereafter, removing the thermoelectric element 1 manufactured in the above procedure from the mold 15 as shown in Fig. 17A, the thermoelectric element 1 in this embodiment is obtained.

Accordingly, the thermoelectric element 1 comprising the first region 3 and the second region 5, which is located at a lateral side of the first region 3 and has a thermal conductivity lower than that of the first region 3, and the protrusion 7 which is located outside of the first region 3 and protruding toward the central axis can be produced. Such protrusion 7 acts as a barrier to inhibit the heat flow flowing through the first region 3, so that the heat transfer within the thermoelectric element 1 can be inhibited.

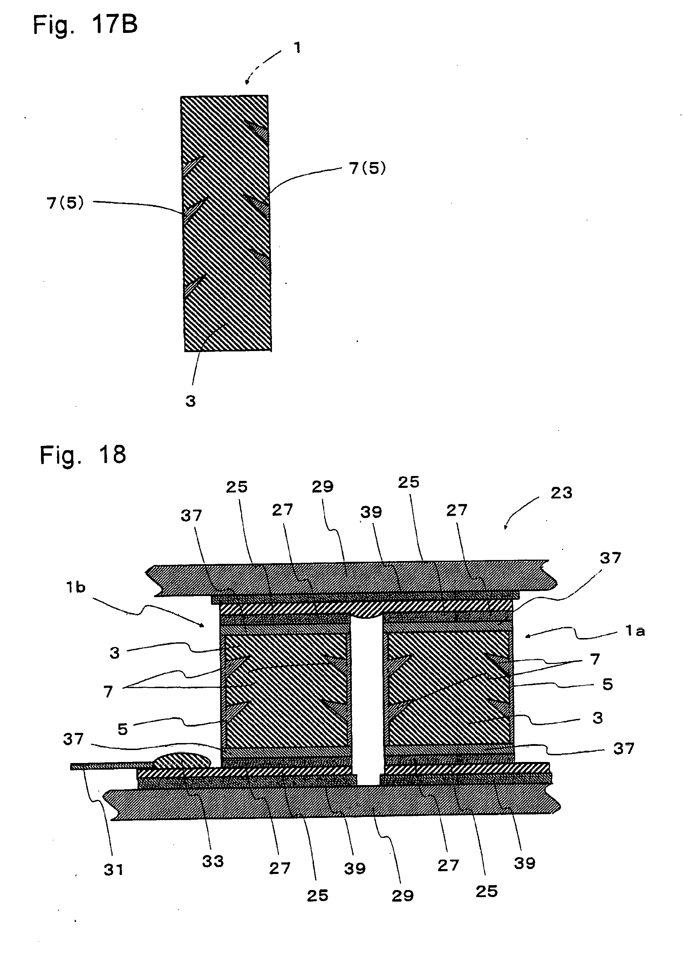

In addition, the second region 5 may be polished so that a plurality of protrusions 7 are separated from each other as shown in Fig. 17B. Moreover, the outer surface of the second region 5 may be covered with a resin coating. By covering the second region 5 with a resin coating, the moisture resistance of the thermoelectric element 1 can be improved, and thereby the durability can be improved.

When compared with the method for manufacturing the thermoelectric element 1 using solidification and molding by hot-pressing as exemplified above, the process of this embodiment has an advantage to form the protrusion 7, which largely improves the thermoelectric properties of the thermoelectric element 1, while having rather simple procedures of steps.

Moreover, in the thermoelectric element 1 manufactured according to the above method using the mold 15, the first region 3 and the second region 5 are integrally molded, so that the effect that the bonding between the first region 3 and the second region 5 is improved can also be obtained.

In the case where the protrusion 7 has a pointed cusp, the protrusion 7 performs the wedge action, so that the close bonding between the regions 3 and 5 can be improved. In the case where each of the first region 3 and the second region 5 is formed separately, stress easily-concentrates on the part of the first region 3 which contacts with the apex 9 when the first region 3 is bonded to the apex 9. However, when the above method is adopted, the first region 3 and the second region 5 are integrally molded, so that the stress applied to the first region 3 can be reduced. As a result, the strength of the thermoelectric element 1 can be improved.

In the process of forming the part C which is coated with the release material 17 and the part D where the inner surface is exposed without being coated with the release material 17 in the first step, the part C may be simply coated with the release material 17. However, it is preferable to form the parts C and D by applying a mask onto the part D and coating the mold with the release material 17 by spraying or printing. As described in the above, by applying a mask onto the part D and coating the whole inner surface of the mold with the release material 17 by spraying or printing, the parts C and D may be formed without adopting complicated steps. In addition, in the process using the mask as mentioned above, the part D may be easily shaped in a desired shape by preliminarily designing the shape of the mask.

In addition, in the first step, it is preferable that the release material 17 is coated onto the inner surface of the mold 15 in a mottled pattern. Thereby, the protrusion 7 may be formed in the circumferential direction without localization.

Here, "the release material 17 is coated onto the inner surface of the mold 15 in a mottled pattern" means that the release material 17 is coated onto the inner surface of the mold 15 so that a plurality of parts C which is coated with the release material 17 are arranged apart from each other, or a plurality of parts D where the inner surface is exposed without being coated with the release material 17 are present being arranged apart from each other.

Moreover, in the case where a plurality of parts, where the inner surface is exposed without being coated with the release material 17, are present, it is possible to produce the thermoelectric element 1 which has a plurality of protrusions 7.

Moreover, in the case where the width of the part D in the end direction, which is not coated with the release material 17, is smaller than the width of the part D in the peripheral direction in the inner lateral surface, it is possible to produce a protrusion 7 having a shape which has a larger length along the peripheral direction than the width in the direction perpendicular to the end face of the thermoelectric element 1.

In addition, in the case where the part D where the inner surface is exposed without being coated with the release material 17 is formed on the inner surface along the entire circumferential length, the protrusion 7 having the shape as shown in Fig. 7 can be produced.

Moreover, it is preferable that the inner surface of the mold 15 has uneveness. It is because the part C and the part D can also be produced in the first step when the inner surface of the mold 15 has uneveness.

In such a case, it is possible to cause particles, which can decrease the wettability with the thermoelectric material, contained in the release material 17 to flow out from the apex of the protruding parts, thereby causing the release material 17 to be selectively concentrated in the recesses, so that the apex of the protruding parts can be exposed. It is preferable that the particles have a size from 0.01 to 0.02 mm. Therefore, the uneven shape is required to have the size that the above particles contained in the release material 17 can flow out from the apex of the protruding parts. Moreover, it is preferable that the uneven shape has a difference in height at most 0.02 mm.

In this manner, by using the mold 15 the inner surface of which was processed to have the uneven shape, it is possible to repeatedly produce the similar thermoelectric element 1. Thus, the above process is excellent in mass productivity and can stabilize the thermoelectric properties of the manufactured thermoelectric element thereby the variation of the products can be inhibited.

This embodiment comprises the third step, wherein the mold 15 into which the solution 35 was introduced is cooled from one end side. Here, "cooled from one end side" means that the temperature of one end side is made lower than the temperature of the other end side. Thus, for example, not only the procedure of cooling one end side of the mold 15, but also the procedure of heating the other end side and the lateral surface of the mold 15 may be applicable.

Moreover, it is preferable that the process comprises a forth step comprising, after the thermoelectric element 1 was manufactured by solidifying the solution 35 through the third step, continuing heating the thermoelectric element 1 for a predetermined period. By continuing heating the thermoelectric element 1 for a predetermined period, the component of the second region 5 diffuses into the first region 3, and the first region 3 becomes to have the intermediate region 13.

As the release material 17, it is not particularly limited, provided that it has less wettability with the thermoelectric material being used than that with the mold 15. Specifically, boron nitride can be used. In particular, boron nitride is preferable, since it has a heat resistance, is resistant to decomposition/evaporation at a high temperature, and is resistant to the reaction with the thermoelectric material and the mold.

As the material of the mold 15, the material having a heat resistance and being resistant to the reaction with the thermoelectric material is preferable. Specifically, carbon and alumina can be used. Particularly, carbon is preferably used, since it has good wettability with the thermoelectric material.

Then, the thermoelectric module of the present invention will be illustrated in detail with reference to the drawings.

As shown in Fig. 18, the thermoelectric module 23 of this embodiment comprises the thermoelectric element 1 of the present invention represented by the above embodiments and a pair of electrodes 25, each of which is electrically connected with one end and the other end of the thermoelectric element 1.

Since the thermoelectric module 23 of this embodiment comprises the thermoelectric element 1 represented by the above embodiments, it has an effect to inhibit the heat flow therethrough due to the protrusion 7 produced in the thermoelectric element 1. Accordingly, it is possible to create a large temperature difference between one end side and the other end side of the thermoelectric module 23 rather than the temperature difference of the conventional thermoelectric modules.

Moreover, it is preferable that the thermoelectric module 23 of this embodiment comprises, as shown in Fig. 18, a plurality of the thermoelectric element 1 each having a protrusion 7, wherein each protrusion 7 has a configuration inclined toward one end side. Since each protrusion 7 inclines toward one end side of the thermoelectric element 1, the effect of inhibiting the heat flow is not discretely performed by each of the thermoelectric elements, but is performed integrally. Thus, the effect of inhibiting the heat flow can be further improved.

In this embodiment, the thermoelectric element 1, as shown in Fig. 18, each of P-type thermoelectric element 1a which generates a positive thermo electromotive force and N-type thermoelectric element 1b which generates a negative thermo electromotive force is used. These P-type thermoelectric elements 1a and N-type thermoelectric elements 1b are alternately arrayed and arranged apart from each other and each of adjacent P-type thermoelectric elements and N-type thermoelectric elements are connected by the electrodes 25, thereby they are electrically connected in series.

The thermoelectric element 1 may be bonded to the electrodes 25 using a bonding material 27, which is for example described below. The bonding member 27, which bonds the thermoelectric element 1 to the electrodes 25 includes solders comprising one or more kinds of component selected from the group consisting of Au, Sn, Ag, Cu, Zn, Sb, Pb, In and Bi; brazing materials comprising one or more kinds of component selected from the group consisting of Ag, Cu, Zn, Ti and A1; and conductive adhesives comprising Ag paste and so forth.

In particular, the solders which are relatively easy to deform are preferable as the bonding materials 27 among the above materials. The thermoelectric module 23 easily generates a large temperature difference between the both faces, so that heat stress is easily generated. Such heat stress is tend to be concentrated at the bonded part. However, by using the solder which is relatively easy to deform as the bonding materials 27, it is possible to improve the durability to the repeated cooling and heating to a large extent.

As the solder, it is preferable that, from the above materials, a solder which contains at least one selected from the group consisting of Sn, Bi, Ag, Cu, Au, Zn and In as the main component. In particular, use of Sb-Sn solder or Au-Sn solder is preferable. It is because such solder improves the bonding strength and the durability of the theremoelectric module.

Moreover, it is preferable that plating layers are formed on both end faces of the thermoelectric element 1. It is because a plating layer formed on the surface facilitates the bonding between the thermoelectric element 1 and the bonding materials 27.

As the electrode 25, a metal having a low resistance such as Cu, Al and so forth may be used. In order to prevent from corrosion and to improve the bonding of the electrode 25 and the bonding material 27, it is preferable to subject the electrode 25 to a plating treatment which forms a plating layer 37 such as Ni plating, Au plating and so forth.

In addition, it is preferable to provide a substrate 29 for fixing the electrode 25 with at least one end side of the heat generating side and heat absorbing side of the thermoelectric module 23. Provision of such substrate 29, the durability of the thermoelectric module 23 against the external force may be improved.

As the substrate 29, a material having an insulating property such as alumina, aluminum nitride, glass ceramics, heat resistant plastics and so forth may be used. In particular, use of an alumina substrate 29 is preferable since it is low cost and it has a consistency of coefficient of thermal expansion with the thermoelectric element. In addition, as the method for bonding the electrode 25 to the substrate 29, any of plating method, metalizing method, coating method and so forth may be used. In addition, bonding using greases or thermal compression bonding may be applicable.

In addition, it is preferable that the surface of the substrate 29 is subjected to the plating treatment, which forms a second plating layer 39 using Ni plating, Au plating and so forth. Forming the second plating layer 39 results in improved bonding between the substrate 29 and the electrode 25.

Each of the thermoelectric elements 1 mounted on the thermoelectric module 23 is electrically connected with the external power supply through a lead-out electrode 31 and a second bonding material 33 which bonds the electrode 25 to the lead-out electrode 31.

As the second bonding material 33 includes, as with the first bonding material 27, the solder comprising one or more kinds of component selected from the group consisting of Au, Sn, Ag, Cu, Zn, Sb, Pb, In and Bi; the brazing material comprising one or more kinds of component selected from the group consisting of Ag, Cu, Zn, Ti and Al; and the conductive adhesive comprising Ag paste and so forth.

### EXAMPLES

The thermoelectric element 1 and the thermoelectric module 23 of the present embodiment were manufactured according to the procedure as follows. First, a P-Type thermoelectric element 1a and a N-Type thermoelectric element 1b as the thermoelectric element 1 were manufactured according to the procedure as follows. As the material for the P-Type thermoelectric element 1a, which was used for the thermoelectric module 23 as shown in Table 1 as Sample No. 1, a thermoelectric material of Bi, Sb, Te was mixed so as to obtain a composition (Bi_{0.2}Sb_{0.8})₂Te₃. Here, the stoichiometric proportion is (Bi_{0.2}Sb_{0.8})₂Te₃.

That is, the P-Type thermoelectric element 1a, which was used for the thermoelectric module 23 as shown in Table 1 as Sample No. 1, was manufactured from a solution wherein the thermoelectric material containing Bi, Sb, Te was mixed in substantially just proportion to obtain the composition (Bi_{0.2}Sb_{0.8})₂Te₃ (standard composition).

In addition, as the material for the P-Type thermoelectric element 1a, which was used for the thermoelectric module 23 as shown in Table 1 as Samples No. 2-5, a thermoelectric material containing Bi, Sb, Te was mixed so as to obtain a composition (Bi_{0.2}Sb_{0.8})₂Te_{3.5}. That is, as the material for the P-Type thermoelectric element 1a, which was used for the thermoelectric module 23 as shown in Table 1 as Samples No. 2-5, a thermoelectric material containing Bi, Sb, Te was mixed so as to obtain a composition (Bi_{0.2}Sb_{0.8})₂Te_{3.5} by adding an excess amount of Te to the basic composition (Bi_{0.2}Sb_{0.8})₂Te₃.

In the material for the P-Type thermoelectric element 1a, which was used for the thermoelectric module 23 as shown in Table 1 as Samples No. 2-5, Bi and Sb are used as the first component and Te is used as the second component. Then, using the above thermoelectric materials having the above composition wherein an excess amount of Te as the second component was added, these P-Type thermoelectric elements were manufactured.

In addition, as the material for the N-Type thermoelectric element 1b, in any of Samples No. 1-5, a thermoelectric material, wherein the metal materials containing Bi, Sb, Te, Se was mixed so as to obtain the composition (Bi_{0.9}Sb_{0.1})₂(Te_{0.95}Se_{0.05})₃. was used. In addition, each of 0.5 % by weight of SbI₃ and SbBr₃ was added to the N-Type thermoelectric element 1b, respectively.

Each of the above thermoelectric materials was melted and mixed under the condition of Ar atmosphere, at a temperature of 650 °C and for 3 hours, and then cooled to obtain each alloy, respectively.

Each alloy was placed on each top of mold 15 (Φ2mm (inside diameter: 2mm)) made of carbon and a weight made of carbon was placed on each alloy, respectively. The mold 15 and the alloy in this condition were heated by a heater to a temperature of 650 °C, thereby each alloy being melted and introduced into each corresponding mold 15.

As to the mold 15 made of carbon, which was used to produce the Samples No. 2-5 of the P-Type thermoelectric elements, the inner lateral surface thereof was preliminarily polished by a brush, so that the inner lateral surface has an unevenly shaped surface. In addition, the inner lateral surface was spray coated with a release material 17 containing boron nitride particles having a mean diameter of 0.01 to 0.02 mm.

By forming the inner lateral surface and spray coated with boron nitride as mentioned in the above, the boron nitride particles were flowed out from the surface of the protruding parts on the inner lateral surface, thereby a condition that carbon inner surface was exposed at the surface of the protruding parts and the surface of the recess was coated with the boron nitride particles could be obtained.

In Sample No. 2, the inner lateral surface of the mold 15 was partially coated with the release material 17 containing boron nitride, thereby parts C, each of which being coated with the release material 17, were formed so as to be arranged apart from each other. Specifically, the amount of the coated boron nitride is 1-2 g/m² expressed by a ratio of the weight to the area of the inner lateral surface of the mold. In Samples 3-5, the entire inner lateral surface of the mold 15 was coated with the release material 17 containing boron nitride in an amount of 5-6 g/m², thereby the parts D, where the inner surface being exposed without being coated with the release material 17, were formed so as to be arranged apart from each other.

In addition, using a heater which heats the other end side and the lateral side of the mold 15, the other end side and the lateral side of the mold were heated, while the one end side was cooled. Then, each mold 15 was pulled out from the heater at each of predetermined rate, thereby 200 wire rods each having 100 mm length and 2 mm diameter were obtained.

As to the N-Type thermoelectric element 1b and Sample No. 1 of the P-Type thermoelectric element 1a, each single crystalline wire rod was obtained by pulling out the mold 15 from the heater at a rate of 5 mm/h.

On the other hand, as to Samples 2 and 3 of the P-Type thermoelectric element 1a, each single crystalline wire rod was obtained by pulling out the mold 15 from the heater at a rate of 1 mm/h. As to Sample 4 of the P-Type thermoelectric element 1a, the single crystalline wire rod was obtained by pulling out the mold 15 from the heater at a rate of 2.5 mm/h. In addition, as to Sample 5 of the P-Type thermoelectric element 1a, the single crystalline wire rod was obtained by pulling out the mold 15 from the heater at a rate of 5 mm/h.

Each lateral side of each wire rod thus obtained was coated with a resin coating as a plating resist and cut to have a 3 mm width (length). After cutting, cut section was etched and then subjected to Ni plating through electrolytic barrel plating. Thereafter, the wire rod was subjected to Sn plating through electrolytic barrel plating.

Finally, as to Samples No. 2-5 of P-Type thermoelectric element 1a, the thermoelectric element 1a after plated was immersed into acetone and subjected to the ultrasonic cleaning, thereby the plating resist was removed. However, as to Sample No. 1 of P-Type thermoelectric element 1a, the plating resist was not removed. Since Sample No. 1 of P-Type thermoelectric element 1a does not have the second region 5, the resin coating as the plating resist was used in place of the second region 5. Then, Samples No. 2-5 of P-Type thermoelectric elements 1a each having the second region 5 were compared with Sample No. 1.

Then, method for manufacturing the thermoelectric module 23 and the evaluation method are explained.

Each one hundred P-Type thermoelectric elements 1a and N-Type thermoelectric elements 1b, obtained from wire rods was placed on an alumina substrate 29, which has a predetermined electrode pattern, and connected in series so that P-Type thermoelectric elements 1a and N-Type thermoelectric elements 1b are alternately arranged using Sb-Sn solder. In addition, two lead wires as lead-out electrodes 31 were connected with the electrodes 25 using Sb-Sn solder as the second bonding material, thereby the thermoelectric modules 23 were manufactured.

As to each of the manufactured thermoelectric modules 23 of Samples No. 1-5, the temperature difference between the top and the bottom substrates 29 (delta T (ΔT)) was measured. Then, comparing the measured delta T of Samples No. 2-5 each of which has the protrusion 7 with the measured the delta T of Sample No. 1 which does not have the protrusion 7, the cooling properties of the thermoelectric modules 23 were evaluated. In this procedure, the substrate 29 of heat releasing side was contacted with a heat sink to maintain a temperature of 27±3 °C and 5 ampere of electric current was applied. Each temperature of the substrates 29 at the one end side and at the other end side was measured using thermocouple and the temperature difference (delta T) between the substrates 29 at the one end side and at the other end side was evaluated.

The durability of the thermoelectric modules 23 was evaluated by subjecting the thermoelectric modules to reversal current test. Specifically, each substrate 29 at the one end side and the other end side was contacted with each heat sink, maintaining a temperature of 27 ± 3 °C and applied 2 ampere of electric current. As the reversal condition, electric current was applied so that the direction of the applied electric current was reversed periodically every ten seconds. The reversal current test was performed for 10,000 cycles, wherein one cycle consists of 20 seconds (twice reverse). The durability properties were evaluated from the bonding between the second region 5 and the first region 3 after the reversal current test.

**[Table 1]**

| Sample No. | Composition of P-Type Thermoelectric Element | Pulling Rate [mm/h] | Boron Nitride Coating | lateral side | | Thermoelectric Properties (delta T [°C]) | Evaluation of Durability (10000 cycles) |
|---|---|---|---|---|---|---|---|
| | | | | Material | Shape | | |
| 1 | (Bi0.2Sb0.8)2Te3 | 5 | none | resin | area 7 being absent | 67.0 | peeled |
| 2 | (Bi0.2sb0.8)2Te3.5 | 1 | partially coated | Te | Fig. 1 | 69.0 | not peeled |
| 3 | (Bi0.2Sb0.8)2Te3.5 | 1 | entirely coated | Te | Fig. 2 | 69.2 | not peeled |
| 4 | (Bi0.2Sb0.8)2Te3.5 | 2.5 | entirely coated | Te | Fig. 3 | 69.5 | not peeled |
| 5 | (Bi0.2Sb0.8)2Te3.5 | 5 | entirely coated | Te | Fig. 4 | 69.6 | not peeled |

As to the P-Type thermoelectric element 1a of Sample No. 1 of the thermoelectric module 23, the delta T was 67.0 °C (ΔT=67.0 °C) as shown in Table 1, since the second region 5 does not have the protrusion 7, which extends from the lateral side of the first region 3 toward the center. In addition, Sample No. 1 of the thermoelectric module 23 after subjected to the reversal current test was observed with an optical microscope and found that the resin coating was peeled at least a part in some of the P-Type thermoelectric elements 1a.

On the other hand, a section of the P-Type thermoelectric element 1a of Samples No. 2-5 of the thermoelectric module 23 was analyzed by EPMA and found that, in each P-Type thermoelectric element 1a of each sample, the second region 5 contained more Te than the first region 3. In addition, it was found that each P-Type thermoelectric element 1a of each sample has the second region 5 each having the protrusion 7 in the shape as explained below.

Then, it was found that each of Samples No. 2-5 of the thermoelectric module 23 has a larger delta T rather than Sample No. 1 of the thermoelectric module 23 and has improved thermoelectric properties since the thermoelectric element 1 has the protrusion 7.

Moreover, each of Samples No. 2-5 of the thermoelectric module 23 after subjected to the reversal current test was observed with an optical microscope and found that the appearance of the thermoelectric element 1a showed no change and the second region 5 did not peel from the first region 3. Accordingly, it was found that the first region 3 and the second region 5 were integrally molded, so that bonding between the first region 3 and the second region 5 was improved.

Moreover, the lateral surface of the first region 3 is coated with the second region 5, thereby the first region 3 is prevented from contacting with the external atmosphere. Thus, as mentioned in the above, the thermoelectric properties of the thermoelectric element 1 could be improved. In addition, since the first region 3 is prevented from contacting with the external atmosphere, the degradation of the first region 3 could be suppressed.

A section of the P-Type thermoelectric element 1a of Sample No. 2 of the thermoelectric module 23, which was manufactured according to the above method, was analyzed by EPMA and found that it has the second region 5 contained more Te than the first region 3 and the second region 5 has the protrusion 7 in the shape as shown in Fig. 1. As described, the P-Type thermoelectric element 1a of Sample No. 2 has the second region 5 having the protrusion 7 and showed the delta T of 69.0 °C (ΔT=69.0 °C), so that the thermoelectric properties thereof have been improved rather than Sample No. 1 of the thermoelectric module 23 which does not have the second region 5 having a protrusion 7.

A section of the P-Type thermoelectric element 1a of Sample No. 3 of the thermoelectric module 23, which was manufactured according to the above method, was analyzed by EPMA and found that it has the second region 5 having the protrusion 7 in the shape as shown in Fig. 2. As to the reason why the protrusion 7 in the shape as shown in Fig. 2 was produced, it may be said that the entire inner lateral surface of the mold 15 was coated with the release material 17 containing boron nitride in an amount of 5-6 g/m², thereby the parts D, where the inner surface is exposed without being coated with the release material 17, were formed so as to be arranged apart from each other.

Comparing with the method for manufacturing the P-Type thermoelectric element of Sample No. 2, the area of the part D is smaller in the method for manufacturing Sample No. 3. Thus, the second component intensively precipitated adjacent the part D and the protrusion 7 having an acute angle shape has been produced.

As described, the P-Type thermoelectric element 1a of Sample No. 3 has the protrusion 7 having an acute angle shape and showed the delta T of 69.2 °C, so that the thermoelectric properties of Sample No. 3 have been improved rather than Sample No. 2 of the thermoelectric module 23.

A section of the P-Type thermoelectric element 1a of Sample No. 4 of the thermoelectric module 23, which was manufactured according to the above method, was analyzed by EPMA and found that it has the protrusion 7 in the shape as shown in Fig. 3. As to the reason why the protrusion 7 in the shape as shown in Fig. 3 was produced, it may be said that the pulling rate of the mold 15 from the heater being 2.5 mm/h was faster than that of any of Samples 2 and 3, so that the crystal grew in the pulling direction which is perpendicular to the end faces of the thermoelectric element 1.

As described, the P-Type thermoelectric element 1a of Sample No. 4 has the protrusion 7 which is inclined toward one end side and have an acute angle shape and showed the delta T of 69.5 °C (ΔT = 69.5 °C), so that the thermoelectric properties of Sample No. 4 have been improved rather than Sample No. 3 of the thermoelectric module 23.

A section of the P-Type thermoelectric element 1a of Sample No. 5 of the thermoelectric module 23, which was manufactured according to the above method, was analyzed by EPMA and found that it has the protrusion 7 in the shape as shown in Fig. 4. As to the reason why the protrusion 7 in the shape as shown in Fig. 4 was produced, it may be said that the pulling rate of the mold 15 from the heater being 5 mm/h was faster than that of any of Samples 2-4, so that the crystal grew in a direction which is more inclined toward the pulling direction which is perpendicular to the end faces of the thermoelectric element 1.

As described, the thermoelectric module 23 of Sample No. 5 has the protrusion 7 having an acute angle shape and showed the delta T of 69.6 °C (ΔT=69.6 °C), so that the thermoelectric properties of Sample No. 5 have been improved rather than the thermoelectric module 23 of Sample No. 4.

In this embodiment, the P-Type thermoelectric elements 1a were evaluated. However, as to the N-Type thermoelectric elements 1b, by adding Te in an excess amount, the thermoelectric element 1 comprising the first region 3 which contains the central axis and the second region 5 which is located at outside of the first region 3 and having a protrusion 7 which protrudes toward the central axis, wherein the second region 5 has lower thermal conductivity than the first region 3 can be manufactured.

## Claims

1. A thermoelectric element (1) having a pillar shape and having one end face and the other end face comprising;
a first region (3) containing a central axis; and
a second region (5) located at outside of the first region,
wherein the first region has a thermal conductivity different from that of the second region,
**characterized in that** the element comprises a protrusion (7) which protrudes toward the central axis.

2. The thermoelectric element (1) according to claim 1, wherein the thermal conductivity of the second region (5) is lower than that of the first region (3).

3. A thermoelectric element (1) according to claim 1,
wherein the first region (3) comprises Te and at least one element selected from the group consisting of Bi, Sb, Se, I and Br;
wherein the second region (5) comprises Te and at least one element selected from the group consisting of Bi, Sb, Se, I and Br;
and wherein the content percentage of Te in the second region (5) is higher than the content percentage in the first region (3).

4. The thermoelectric element (1) according to claim 1, wherein the protrusion (7) comprises an apex (9) and two peripheral regions in a section containing the central axis, and
wherein a straight line connecting one peripheral region at the side closer to the one end side of the thermoelectric element (1) and the apex (9) intersects with another straight line connecting one peripheral region at the side closer to the other end side of the thermoelectric element (1) and the apex (9) at an acute angle.

5. The thermoelectric element (1) according to claim 4, wherein the apex (9) is located at a position which is closer to the one end side than a plane which is perpendicular to the central axis and contains the midpoint between the two peripheral regions.

6. The thermoelectric element (1) according to claim 5, wherein the apex (9) is located at a position which is closer to the one end side than a plane which is perpendicular to the central axis and contains one peripheral portion which is located closer to the one end side.

7. The thermoelectric element (1) according to claim 1, wherein the second region (5) comprises a plurality of protrusions (7).

8. The thermoelectric element (1) according to claim 1, wherein the protrusion (7) has a larger width in the direction perpendicular to the central axis than a width in the direction parallel to the central axis in a section which is parallel to the central axis.

9. The thermoelectric element (1) according to claim 1, wherein the protrusion (7) is formed in an annular form so as to surround the first region (3).

10. The thermoelectric element (1) according to claim 1, wherein the second region (5) covers the lateral side of the first region (3).

11. The thermoelectric element (1) according to claim 1, wherein the first region (3) contains the main composition of the second region (5).

12. The thermoelectric element(1) according to claim 11, wherein the first region (3) comprises a center part containing the central axis and an intermediate region (13), which is located between the center part and the second region (5) and which contains a larger quantity of the main component of the second region (5) than the central portion.

13. A thermoelectric module (23) wherein a plurality of thermoelectric elements (1) according to claim 1 are arrayed, wherein two adjacent thermoelectric elements (1) are alternately connected by a first electrode on the one end side and two adjacent thermoelectric elements (1), which are not connected by the first electrode on the one end side, are connected by a second electrode on the other end side, thereby the thermoelectric elements (1) are connected in series.

14. A thermoelectric module (23) according to claim 13, wherein each of the protrusions (7) is inclined toward one end side.

15. A method for manufacturing a thermoelectric element (1) comprising;
a first step of coating a part of an inner surface of a mold (15) with a release material (17);
a second step of introducing a solution of thermoelectric element (1) which contains a first component and a second component, wherein the solution contains the second component in an excess amount, so that the proportion of the second component becomes higher than that in the stoichiometric proportion of the particular compound consisting of the first component and the second component; and
a third step of cooling the mold (15) into which the solution being introduced from one end side.

## Patentansprüche

1. Thermoelektrisches Element (1) mit einer Säulenform und mit einer Endfläche und einer anderen Endfläche, umfassend:
einen ersten Bereich (3), umfassend eine zentrale Achse, und
einen zweiten Bereich (5), der an der äußeren Seite des ersten Bereiches lokalisiert ist,
worin der erste Bereich eine thermische Leitfähigkeit hat, die verschieden ist von der des zweiten Bereiches,
**dadurch gekennzeichnet, dass** das Element einen Vorsprung (7) enthält, der in Richtung zur zentralen Achse vorsteht.

2. Thermoelektrisches Element (1) nach Anspruch 1, worin die thermische Leitfähigkeit des zweiten Bereiches (5) niedriger ist als die des ersten Bereiches (3).

3. Thermoelektrisches Element (1) nach Anspruch 1,
worin der erste Bereich (3) Te und zumindest ein Element enthält, ausgewählt aus der Gruppe bestehend aus Bi, Sb, Se, I und Br,
worin der zweite Bereich (5) Te und zumindest ein Element enthält, ausgewählt aus der Gruppe bestehend aus Bi, Sb, Se, I und Br, und
worin der Gehalt in Prozent von Te des zweiten Bereiches (5) höher ist als der Gehalt in Prozent im ersten Bereich (3).

4. Thermoelektrisches Element (1) nach Anspruch 1, worin der Vorsprung (7) einen Scheitel (9) und zwei periphere Bereiche in einem Bereich enthält, der die zentrale Achse enthält, und
worin eine gerade Linie, die einen peripheren Bereich an der Seite, die näher an der einen Endseite des thermoelektrischen Elementes (1) liegt, und den Scheitel (9) verbindet, eine andere gerade Linie, die einen peripheren Bereich an der Seite, die enger an der einen Endseite des thermoelektrischen Elementes (1) liegt, und den Scheitel (9) bei einem spitzen Winkel schneidet.

5. Thermoelektrisches Element nach Anspruch 4, worin der Scheitel (5) an einer Position lokalisiert ist, die enger an der einen Endseite ist als eine Ebene, die senkrecht zu der zentralen Achse ist, und den Mittelpunkt zwischen den beiden peripheren Bereichen enthält.

6. Thermoelektrisches Element (1) nach Anspruch 5, worin der Scheitel (9) an einer Position lokalisiert ist, die enger an der einen Endseite ist als eine Ebene, die senkrecht zu der zentralen Achse ist, und einen peripheren Bereich enthält, der enger an der einen Endseite lokalisiert ist.

7. Thermoelektrisches Element (1) nach Anspruch 1, worin der zweite Bereich (5) eine Vielzahl von Vorsprüngen (7) enthält.

8. Thermoelektrisches Element (1) nach Anspruch 1, worin der Vorsprung (7) eine größere Breite in der Richtung senkrecht zu der zentralen Achse hat als eine Breite in der Richtung parallel zu der zentralen Achse in einem Bereich, der parallel zu der zentralen Achse ist.

9. Thermoelektrisches Element (1) nach Anspruch 1, worin der Vorsprung (7) in einer ringförmigen Form gebildet ist, so dass der erste Bereich (3) umgeben ist.

10. Thermoelektrisches Element (1) nach Anspruch 1, worin der zweite Bereich (5) die laterale Seite des ersten Bereiches (3) bedeckt.

11. Thermoelektrisches Element (1) nach Anspruch 1, worin der erste Bereich (3) die Hauptzusammensetzung des zweiten Bereiches (5) enthält.

12. Thermoelektrisches Element (1) nach Anspruch 11, worin der erste Bereich (3) ein zentrales Teil enthält, das die zentrale Achse und einen Zwischenbereich (13) enthält, der zwischen dem zentralen Teil und dem zweiten Bereich (5) lokalisiert ist und eine größere Menge der Hauptkomponente des zweiten Bereiches (5) als der zentrale Bereich enthält.

13. Thermoelektrisches Modul (23), worin eine Vielzahl von thermoelektrischen Elementen (1) nach Anspruch 1 angeordnet sind, worin zwei benachbarte thermoelektrische Elemente (1) alternativ durch eine erste Elektrode an der einen Endseite verbunden sind und zwei benachbarte thermoelektrische Elemente (1), die nicht durch die erste Elektrode an der einen Endseite verbunden sind, durch eine zweite Elektrode an der anderen Endseite verbunden sind, wodurch die thermoelektrischen Elemente (1) in Serie verbunden sind.

14. Thermoelektrisches Modul (23) nach Anspruch 13, worin jeder Vorsprung (7) in Richtung zu einer Endseite geneigt ist.

15. Verfahren zur Herstellung eines thermoelektrischen Elementes (1), umfassend:
einen ersten Schritt der Beschichtung eines Teils einer Innenoberfläche einer Form (15) mit einem Freisetzungsmaterial (17),
einen zweiten Schritt des Einführens einer Lösung aus dem thermoelektrischen Element (1), das eine erste Komponente und eine zweite Komponente enthält, worin die Lösung die zweite Komponente in einer überschüssigen Menge enthält, so dass der Anteil der zweiten Komponente höher wird als der in dem stöchiometrischen Anteil der bestimmten Verbindung, die aus der ersten Komponente und der zweiten Komponente besteht, und
einen dritten Schritt des Kühlens der Form (15), in die die Lösung von einer Endseite eingefügt wird.

## Revendications

1. Elément thermoélectrique (1) présentant une forme de pilier et comportant une face d'extrémité et une autre face d'extrémité comprenant :
une première région (3) contenant axe central ; et
une seconde région (5) située à l'extérieur de la première région,
dans lequel la première région possède une conductivité thermique différente de celle de la seconde région,
**caractérisé en ce que** l'élément comprend une protubérance (7) qui fait saillie vers l'axe central.

2. Elément thermoélectrique (1) selon la revendication 1, dans lequel la conductivité thermique de la seconde région (5) est inférieure à celle de la première région (3).

3. Elément thermoélectrique (1) selon la revendication 1,
dans lequel la première région (3) comprend Te et au moins un élément sélectionné parmi le groupe constitué de Bi, Sb, Se, I et Br ;
dans lequel la seconde région (5) comprend Te et au moins un élément sélectionné parmi le groupe constitué de Bi, Sb, Se, I et Br ;
et dans lequel le pourcentage de teneur en Te dans la seconde région (5) est supérieur au pourcentage de teneur dans la première région (3).

4. Elément thermoélectrique (1) selon la revendication 1, dans lequel la protubérance (7) comprend un sommet (9) et deux régions périphériques dans une section contenant l'axe central, et
dans lequel une ligne droite reliant une région périphérique sur la face plus près de l'une face d'extrémité de l'élément thermoélectrique (1) et le sommet (9) croise une autre ligne droite reliant une région périphérique sur la face plus près de l'autre face d'extrémité de l'élément thermoélectrique (1) et le sommet (9) à un angle aigu.

5. Elément thermoélectrique (1) selon la revendication 4, dans lequel le sommet (9) est situé dans une position qui est plus près de l'une face d'extrémité qu'un plan qui est perpendiculaire à l'axe central et contient le point médian entre les deux régions périphériques.

6. Elément thermoélectrique (1) selon la revendication 5, dans lequel le sommet (9) est situé dans une position qui est plus près de l'une face d'extrémité qu'un plan qui est perpendiculaire à l'axe central et contient une partie périphérique qui est située plus près de l'une face d'extrémité.

7. Elément thermoélectrique (1) selon la revendication 1, dans lequel la seconde région (5) comprend une pluralité de protubérances (7).

8. Elément thermoélectrique (1) selon la revendication 1, dans lequel la protubérance (7) possède une largeur plus importante dans la direction perpendiculaire à l'axe central qu'une largeur dans la direction parallèle à l'axe central dans une section qui est parallèle à l'axe central.

9. Elément thermoélectrique (1) selon la revendication 1, dans lequel la protubérance (7) présente une forme annulaire afin d'entourer la première région (3).

10. Elément thermoélectrique (1) selon la revendication 1, dans lequel la seconde région (5) recouvre le côté latéral de la première région (3).

11. Elément thermoélectrique (1) selon la revendication 1, dans lequel la première région (3) contient la composition principale de la seconde région (5).

12. Elément thermoélectrique (1) selon la revendication 11, dans lequel la première région (3) comprend une partie centrale contenant l'axe central et une région intermédiaire (13), qui est située entre la partie centrale et la seconde région (5) et qui contient une quantité plus importante du composant principal de la seconde région (5) que la partie centrale.

13. Module thermoélectrique (23), dans lequel une pluralité d'éléments thermoélectriques (1) selon la revendication 1 sont mis en réseau, dans lequel deux éléments thermoélectriques adjacents (1) sont connectés alternativement par une première électrode sur l'une face d'extrémité et deux éléments thermoélectriques adjacents (1), qui ne sont pas connectés par la première électrode sur l'une face d'extrémité, sont connectés par une seconde électrode sur l'autre face d'extrémité, ainsi les éléments thermoélectriques (1) sont connectés en série.

14. Module thermoélectrique (23) selon la revendication 13, dans lequel chacune des protubérances (7) est inclinée vers une face d'extrémité.

15. Procédé pour fabriquer un élément thermoélectrique (1), comprenant :
une première étape de revêtement d'une partie d'une surface intérieure d'un moule (15) avec un matériau antiadhérent (17) ;
une deuxième étape d'introduction d'une solution de l'élément thermoélectrique (1) qui contient un premier composant et un second composant, dans lequel la solution contient le second composant en excédent, pour que la proportion du second composant devienne plus élevée que celle dans la proportion stoechiométrique du composé particulier constitué du premier composant et du second composant ; et
une troisième étape de refroidissement du moule (15) dans lequel la solution est introduite à partir d'une face d'extrémité.
